# EUROPEAN PATENT APPLICATION

(11) **EP 4 766 059 A1**
(43) Date of publication of application: **24.06.2026**
(21) Application number: 25224126.0
(22) Date of filing: 16.12.2025
(51) Int. Cl.: H05K 7/20

(54) **COOLING FOR ELECTRONICS OF DATA CENTER**

(30) Priority: 20.12.2024 US 202463736970 P
(71) Applicant: Carrier Corporation, Palm Beach Gardens, FL 33418 (US)
(72) Inventor: SISHTLA, Vishnu, East Syracuse, 13057 (US); HALBE, Chaitanya, East Syracuse, 13057 (US)
(74) Representative: Dehns

(57) **Abstract**

An electronics enclosure system includes an enclosure (10), one or more electronics racks (12) positioned in the enclosure (10) and a cooling system to cool the one or more electronics racks (12). The cooling system includes a plurality of spray nozzles (22) positioned inside the enclosure (10) and configured to spray a cooling fluid onto the electronics rack (12) to cool the electronics rack (12). The plurality of spray nozzles (22) are operably connected to a vapor compression circuit (26) configured to cool the cooling fluid.

A method of cooling an electronics rack (12) includes positioning one or more electronics racks (12) in an enclosure (10), operating a cooling system to spray a cooling fluid onto the electronics rack (12) from a plurality of spray nozzles (22) positioned inside the enclosure (10) to cool the electronics rack (12), and cooling the cooling fluid via a vapor compression circuit (26) operably connected to the plurality of spray nozzles (22).

## Description

### BACKGROUND

Exemplary embodiments pertain to the art of cooling systems, and in particular to cooling of electronics enclosures, such as those utilized in data centers.

The power density of new generation of semiconductors used in data centers is increasing, leading to increasing cooling demand. There are multiple methods of cooling the semiconductors, such as convective cooling, immersion cooling or circulating coolant around the semiconductor chip through coolant distribution units. However, these methods often require complex architecture. The art would welcome a relatively simple solution to cool these increasingly cooling-intensive data centers and other electronics.

### BRIEF DESCRIPTION

In one exemplary embodiment, an electronics enclosure system includes an enclosure, one or more electronics racks positioned in the enclosure and a cooling system to cool the one or more electronics racks. The cooling system includes a plurality of spray nozzles positioned inside the enclosure and configured to spray a cooling fluid onto the electronics rack to cool the electronics rack. The plurality of spray nozzles are operably connected to a vapor compression circuit configured to cool the cooling fluid.

Optionally, the electronics rack is at least partially submerged in a cooling fluid pool in the enclosure.

Optionally, the cooling fluid is a refrigerant circulated through the vapor compression circuit.

Optionally, the refrigerant is directed to a compressor of the vapor compression circuit upon exiting the enclosure.

Optionally, a cooling fluid manifold is configured to distribute the cooling fluid to the plurality of spray nozzles.

Optionally, the cooling fluid emitted from the plurality of spray nozzles is in liquid phase.

Optionally, the enclosure is a plurality of enclosures, and the plurality of enclosures are connected in a fluidly parallel arrangement.

Optionally, a plurality of electronics racks are positioned in the enclosure, and the plurality of nozzles are configured to spray the cooling fluid onto the plurality of electronics racks.

Optionally, an intermediate heat exchanger is configured to exchange thermal energy between the cooling fluid and a refrigerant of the vapor compression circuit.

Optionally, the electronics rack is sealed to prevent an ingress of cooling fluid into the electronics rack.

In another exemplary embodiment, a method of cooling an electronics rack includes positioning one or more electronics racks in an enclosure, operating a cooling system to spray a cooling fluid onto the electronics rack from a plurality of spray nozzles positioned inside the enclosure to cool the electronics rack, and cooling the cooling fluid via a vapor compression circuit operably connected to the plurality of spray nozzles.

Optionally, the electronics rack is at least partially submerged in a cooling fluid pool in the enclosure.

Optionally, the cooling fluid is a refrigerant circulated through the vapor compression circuit.

Optionally, the refrigerant is directed to a compressor of the vapor compression circuit upon exiting the enclosure.

Optionally, the cooling fluid is distributed to the plurality of spray nozzles via a cooling fluid manifold.

Optionally, the cooling fluid is emitted from the plurality of spray nozzles in liquid phase.

Optionally, the enclosure is a plurality of enclosures, and the plurality of enclosures are connected in a fluidly parallel arrangement

Optionally, a plurality of electronics racks are positioned in the enclosure, and the cooling fluid is sprayed from the plurality of nozzles onto the plurality of electronics racks.

Optionally, thermal energy is exchanged between the cooling fluid and a refrigerant of the vapor compression circuit via an intermediate heat exchanger.

Optionally, the electronics rack is sealed to prevent an ingress of cooling fluid into the electronics rack.

### BRIEF DESCRIPTION OF THE DRAWINGS

The following descriptions should not be considered limiting in any way. With reference to the accompanying drawings, like elements are numbered alike:
FIG. 1 is a schematic illustration of a cooling system for an arrangement of electronic components;
FIG. 2 is a schematic illustration of another cooling system for an arrangement of electronic components;
FIG. 3 is a schematic illustration of yet another cooling system for an arrangement of electronic components; and
FIG. 4 is a schematic illustration of still another cooling system for an arrangement of electronic components.

### DETAILED DESCRIPTION

A detailed description of one or more embodiments of the disclosed apparatus and method are presented herein by way of exemplification and not limitation with reference to the Figures.

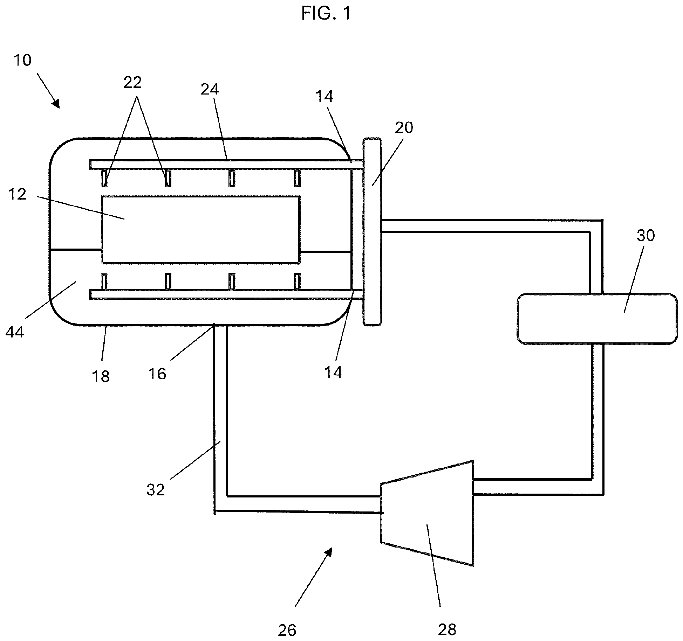

Referring now to FIG. 1, illustrated is an exemplary embodiment of an electronics enclosure 10 containing, for example, an electronics rack 12 including one or more semiconductor devices. The enclosure 10 is configured as a containment vessel, to retain a volume of cooling fluid therein. The enclosure 10 includes at least one cooling fluid inlet 14 and a cooling fluid outlet 16. In some embodiments, the cooling fluid outlet 16 is configured as a drain and is located at a vertically bottom portion 18 of the enclosure 10.

An inlet manifold 20 is configured to distribute the cooling fluid to a plurality of spray nozzles 22 via cooling fluid pathways 24 extending from the inlet manifold 20. In some embodiments, such as shown in FIG. 1, the inlet manifold 20 is located outside of the enclosure 10 with the cooling fluid pathways 24 extending into the enclosure 10 via the cooling fluid inlets 14. In other embodiments, however, the inlet manifold 20 may be located inside of the enclosure 10.

The spray nozzles 22 are configured to spray cooling fluid directly onto the electronics rack 12 to cool the electronics rack 12, and the semiconductor devices therein. In some embodiments, the volume of cooling fluid is such that a cooling fluid pool 44 is located at a bottom of the enclosure 10 and the electronics rack 12 is at least partially submerged in the cooling fluid pool 44. In some embodiments, the electronics racks 12 are sealed to protect the electronic components therein from effects of moisture. This combination of impingement cooling via the spray nozzles 22 and immersion cooling via the cooling fluid pool 44 is highly effective in maintaining the electronics rack 12 at a selected operating temperature.

In some embodiments, the cooling fluid is refrigerant and the enclosure 10 is integrated into a vapor compression circuit 26. The vapor compression circuit 26 includes a compressor 28 that compresses the refrigerant and directs the refrigerant to a condenser 30 which outputs liquid phase refrigerant to the enclosure 10, which is maintained at a pressure lower than a saturation pressure of the refrigerant. The liquid phase refrigerant enters the enclosure 10 and is sprayed onto the electronics rack 12 via the spray nozzles 22. The refrigerant absorbs thermal energy from the electronics rack 12, thus cooling the electronics rack 12, and undergoes a phase change to vapor. The vaporized refrigerant then exits the enclosure 10 via the cooling fluid outlet 16 and is directed to the compressor 28 via a return pathway 32 to repeat the circuit. Exemplary refrigerants may include one or more of R513A, R1233zd(E) and R515B. One skilled in the art will readily appreciate, however, that the listed refrigerant materials are merely exemplary and that other refrigerant materials may be utilized.

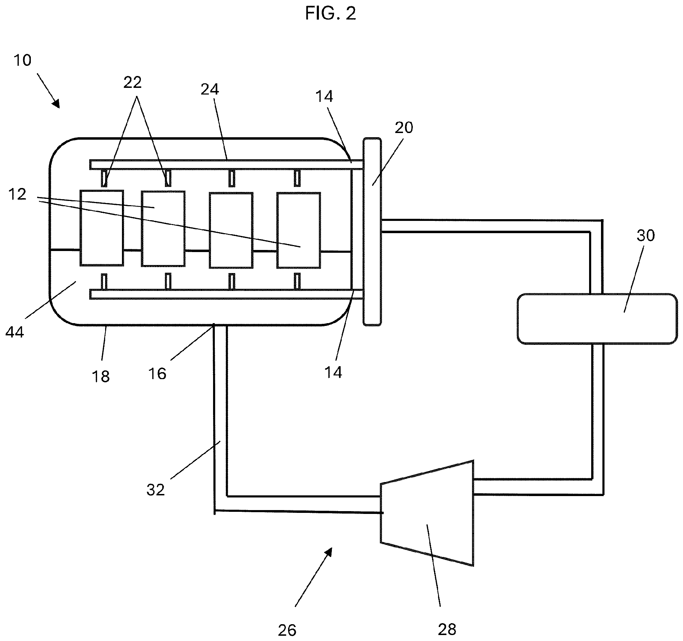

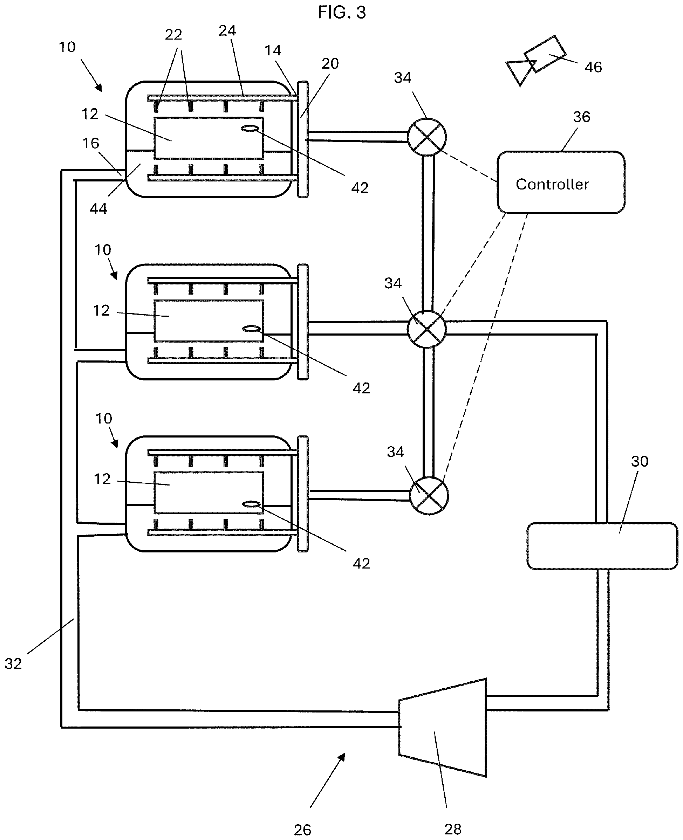

In some embodiments, as illustrated in FIG. 2, the enclosure 10 may contain a plurality of electronics racks 12, with one or more spray nozzles 22 configured to spray cooling fluid on each of the electronics racks 12. In other embodiments, such as illustrated in FIG. 3, multiple enclosures 10, each containing one or more electronics racks 12, are connected to the vapor compression circuit 26 either in series, or alternatively in parallel as illustrated. One or more cooling fluid valves 34 are operable to selectably direct the cooling fluid, or refrigerant, into each of the enclosures 10. The cooling fluid valves 34 may be operably connected to a controller 36 that commands positions of the valves 34 based on, for example, detected temperatures of the electronics racks 12 in each of the enclosures 10. The temperatures may be detected via one or more temperature sensors 42 disposed at each of the electronics racks 12, or alternatively via, for example, a thermal camera 46 or the like which is positioned to detect a temperature profile of each of the enclosures 10. The controller 36 may be connected to the temperature sensors 42 and/or to the thermal camera 46 and is operable to automatically open select valves 34 to direct a greater volume of cooling fluid toward the electronics racks 12 with higher detected temperature.

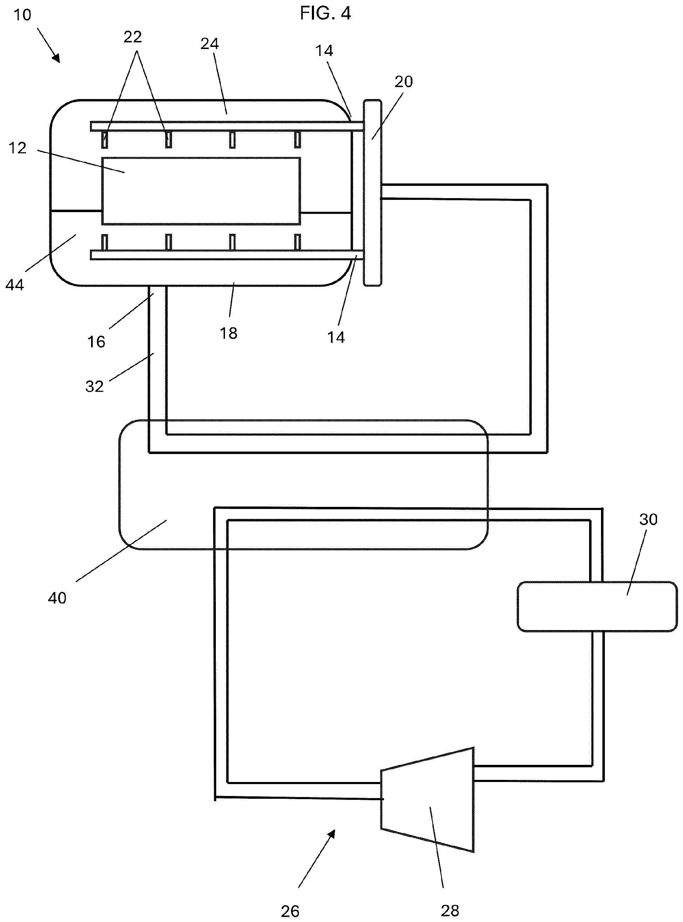

Another embodiment is illustrated in FIG. 4. This embodiment utilizes an intermediate heat exchanger 40 to transfer thermal energy between the flow of refrigerant in the vapor compression circuit 26 and a cooling fluid circuit 38 that circulates the cooling fluid, which in some embodiments is a dielectric fluid, through the enclosure 10 to cool the electronics rack 12 via the spray nozzles 22. The cooling fluid then exits the enclosure 10 through the cooling fluid outlet 16 and is directed to the secondary heat exchanger 36 via the return pathway 32. The flow of refrigerant exchanges thermal energy with the cooling fluid at the secondary heat exchanger 36, which converts the refrigerant to vapor phase while cooling the flow of cooling fluid. From the secondary heat exchanger 36, the flow of refrigerant returns to the compressor 28 to complete the circuit.

The configurations disclosed herein offer simple, cost-effective and reliable systems of achieving high heat transfer rates to cool electronic components of data centers. A properly sealed system also eliminates the issues caused by moisture.

The term "about" is intended to include the degree of error associated with measurement of the particular quantity based upon the equipment available at the time of filing the application.

The terminology used herein is for the purpose of describing particular embodiments only and is not intended to be limiting of the present disclosure. As used herein, the singular forms "a", "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, element components, and/or groups thereof.

While the invention has been described with reference to an exemplary embodiment or embodiments, it will be understood by those skilled in the art that various changes may be made and equivalents may be substituted for elements of the exemplary embodiment without departing from the scope of the invention. In addition, many modifications may be made to adapt a particular situation or material to the teachings herein without departing from the scope of the invention. Therefore, it is intended that the invention not be limited to the particular embodiment disclosed, but that the invention will include all embodiments falling within the scope of the claims.

## Claims

1. An electronics enclosure system, comprising:
an enclosure (10);
one or more electronics rack (12) disposed in the enclosure; and
a cooling system, including:
a plurality of spray nozzles (22) disposed inside the enclosure configured to spray a cooling fluid onto the electronics rack to cool the electronics rack;
wherein the plurality of spray nozzles are operably connected to a vapor compression circuit (26) configured to cool the cooling fluid.

2. The electronics enclosure system of claim 1, wherein the electronics rack is at least partially submerged in a cooling fluid pool (44) in the enclosure.

3. The electronics enclosure system of claim 1 or 2, wherein the cooling fluid is a refrigerant circulated through the vapor compression circuit
, optionally, wherein the refrigerant is directed to a compressor of the vapor compression circuit upon exiting the enclosure.

4. The electronics enclosure system of claim 1 or 2, further comprising an intermediate heat exchanger (40) configured to exchange thermal energy between the cooling fluid and a refrigerant of the vapor compression circuit.

5. The electronics enclosure system of any preceding claim, further comprising a cooling fluid manifold (20) configured to distribute the cooling fluid to the plurality of spray nozzles.

6. The electronics enclosure system of any preceding claim, wherein the cooling fluid emitted from the plurality of spray nozzles is in liquid phase; and/or
wherein the electronics rack is sealed to prevent an ingress of cooling fluid into the electronics rack.

7. The electronics enclosure system of any preceding claim, wherein the enclosure is a plurality of enclosures, the plurality of enclosures being connected in a fluidly parallel arrangement.

8. The electronics enclosure system of claim 1, wherein the one or more electronics rack comprises a plurality of electronics racks disposed in the enclosure, the plurality of nozzles being configured to spray the cooling fluid onto the plurality of electronics racks.

9. A method of cooling an electronics rack (12), comprising:
positioning one or more electronics rack (12) in an enclosure (10); and
operating a cooling system to spray a cooling fluid onto the electronics rack from a plurality of spray nozzles (22) disposed inside the enclosure to cool the electronics rack; and
cooling the cooling fluid via a vapor compression circuit (26) operably connected to the plurality of spray nozzles.

10. The method of claim 9, further comprising at least partially submerging the electronics rack in a cooling fluid pool in the enclosure.

11. The method of claim 9 or 10, wherein the cooling fluid is a refrigerant circulated through the vapor compression circuit,
optionally further comprising directing the refrigerant to a compressor of the vapor compression circuit upon exiting the enclosure.

12. The method of claim 9 or 10, further comprising exchanging thermal energy between the cooling fluid and a refrigerant of the vapor compression circuit via an intermediate heat exchanger (40).

13. The method of any of claims 9 to 12, further comprising distributing the cooling fluid to the plurality of spray nozzles via a cooling fluid manifold (20), and/or
emitting the cooling fluid from the plurality of spray nozzles in liquid phase, and/or
sealing the electronics rack to prevent an ingress of cooling fluid into the electronics rack.

14. The method of any of claims 9 to 13, wherein the enclosure is a plurality of enclosures, the plurality of enclosures being connected in a fluidly parallel arrangement.

15. The method of any of claims 9 to 14, wherein positioning the one or more electronics rack in the enclosure comprises positioning a plurality of electronics racks in the enclosure, and wherein operating the cooling system comprises spraying the cooling fluid from the plurality of nozzles onto the plurality of electronics racks.
